(19) Europäisches Patentamt
European Patent Office
Office européen des brevets

(11) **EP 4 694 642 A1**

(12) **EUROPEAN PATENT APPLICATION**
published in accordance with Art. 153(4) EPC

(43) Date of publication:
**11.02.2026 Bulletin 2026/07**

(21) Application number: **23929986.0**

(22) Date of filing: **24.11.2023**

(51) International Patent Classification (IPC):
*H10K 59/121* (2023.01)    *H10K 59/12* (2023.01)
*H10K 59/131* (2023.01)    *H10K 59/124* (2023.01)

(52) Cooperative Patent Classification (CPC):
**H10K 59/12; H10K 59/121; H10K 59/124;
H10K 59/131**

(86) International application number:
**PCT/CN2023/133823**

(87) International publication number:
**WO 2024/198418 (03.10.2024 Gazette 2024/40)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **30.03.2023 CN 202310350586**

(71) Applicant: **Wuhan China Star Optoelectronics
Semiconductor
Display Technology Co., Ltd.
Wuhan, Hubei 430079 (CN)**

(72) Inventor: **WU, Yongbo
Wuhan, Hubei 430079 (CN)**

(74) Representative: **Zhu, Puxing
Mars Universe IP
c/o Spaces
Mühldorfstraße 8
81671 München (DE)**

(54) **DISPLAY PANEL AND DISPLAY DEVICE**

(57)    A display panel and a display device are disclosed. The display panel includes an insulating layer, a first metal layer, a first planarization layer, and an electrode layer which are sequentially disposed; where the insulating layer includes a plurality of first grooves; the first metal layer includes a plurality of first traces disposed corresponding to the plurality of first grooves, and the first traces are disposed in the first grooves; the first planarization layer continuously covers the first traces and the insulating layer; and the electrode layer includes a plurality of pixel electrodes, and the pixel electrodes are arranged to be at least partially overlapped with the corresponding first traces.

FIG. 5

EP 4 694 642 A1

## Description

TECHNICAL FIELD

The present application relates to the field of display technology, and specifically relates to a display panel and a display device.

BACKGROUND

Currently, the pixel luminescent quality of an OLED display panel is affected by a plurality of factors, where researches related to the influence of pixel flatness on the pixel luminescent quality are relatively few. The principle of how the pixel flatness affects the pixel luminescent quality is as follows: if a pixel surface is not flat, for example, in an uneven shape, when external light irradiates a screen body, reflection on the pixel surface will also be enhanced, and various diffuse reflection phenomena will occur. At this time, a light-emitting surface of the display panel will present colorful reflected light, and this phenomenon is referred to as "color separation".

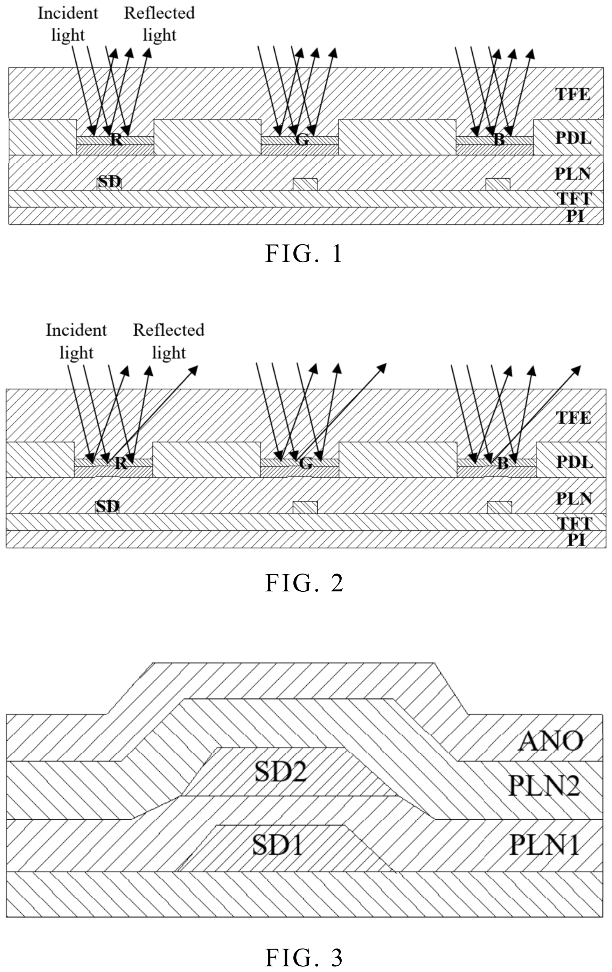

As shown in FIG. 1, when the pixel surface is flat, a reflection range of reflected light on the pixel surface is small, and human eyes will not see the reflected light under a large viewing angle, so the color separation phenomenon of the display panel is also relatively slight. As shown in FIG. 2, when the pixel surface is not flat, diffuse reflection will occur on the pixel surface, and human eyes can still see the reflected light under the large viewing angle, and at this time, the display panel will show a relatively serious color separation phenomenon.

Therefore, in order to reduce the color separation phenomenon of the display panel, it is necessary to make the pixels as flat as possible.

TECHNICAL ISSUES

The present application provides a display panel and a display device, which can effectively improve flatness of pixel electrodes in the display panel, and are beneficial to reducing or even eliminating the color separation phenomenon of the display panel.

TECHNICAL SOLUTIONS

The present application provides a display panel, including:

a base substrate;

an insulating layer, disposed on a side of the base substrate; where the insulating layer includes a plurality of first grooves;

a first metal layer, disposed on a side of the insulating layer away from the base substrate; where the first metal layer includes a plurality of first traces disposed in a one-to-one correspondence with the plurality of first grooves, and the first traces are disposed in the corresponding first grooves;

a first planarization layer, disposed on a side of the first metal layer away from the base substrate; where the first planarization layer continuously covers the first traces and the insulating layer; and

an electrode layer, disposed on a side of the first planarization layer away from the base substrate; where the electrode layer includes a plurality of pixel electrodes, and the pixel electrodes are arranged to be at least partially overlapped with the corresponding first traces.

The present application further provides a display panel, including:

a base substrate;

a first metal layer, disposed on a side of the base substrate; where the first metal layer includes a plurality of first traces;

a first planarization layer, disposed on a side of the first metal layer away from the base substrate; where the first planarization layer continuously covers the first traces and the base substrate;

a second metal layer, disposed on a side of the first planarization layer away from the base substrate; where the second metal layer includes a plurality of second traces, and the second traces are arranged to be not overlapped with the first traces;

a second planarization layer, disposed on a side of the second metal layer away from the base substrate; where the second planarization layer continuously covers the second traces and the first planarization layer; and

an electrode layer, disposed on a side of the second planarization layer away from the base substrate; where the electrode layer includes a plurality of pixel electrodes, and the pixel electrodes are arranged to be at least partially overlapped with both the corresponding first traces and the corresponding second traces.

The present application further provides a display device, including the above-described display panel; where the display panel further includes a light-emitting functional layer located on the pixel electrodes.

BRIEF DESCRIPTION OF THE DRAWINGS

The technical solutions and other beneficial effects of the present application will become apparent from the following detailed description of the specific embodiments of the present application in conjunction with the accompanying drawings.

FIG. 1 is a schematic diagram of light reflection on a light incident side of a display panel when a pixel surface in an exemplary display panel is flat.

FIG. 2 is a schematic diagram of light reflection on the light incident side of the display panel when the pixel surface in the exemplary display panel is uneven.

FIG. 3 is a schematic diagram of a partial structure of an exemplary display panel.

FIG. 4 is a schematic diagram of a partial structure of a display panel provided in an embodiment of the present application.

FIG. 5 is a schematic diagram of a partial structure of an array substrate provided in an embodiment of the present application.

FIG. 6 is a schematic diagram of a partial structure of another array substrate provided in an embodiment of the present application.

FIG. 7 is a schematic diagram of a partial structure of yet another array substrate provided in an embodiment of the present application.

FIG. 8 is a schematic diagram of a partial structure of still another array substrate provided in an embodiment of the present application.

DETAILED DESCRIPTION

The present application provides a display panel, including:

a base substrate;

an insulating layer, disposed on a side of the base substrate; where the insulating layer includes a plurality of first grooves;

a first metal layer, disposed on a side of the insulating layer away from the base substrate; where the first metal layer includes a plurality of first traces disposed in a one-to-one correspondence with the plurality of first grooves, and the first traces are disposed in the corresponding first grooves;

a first planarization layer, disposed on a side of the first metal layer away from the base substrate; where the first planarization layer continuously covers the first traces and the insulating layer; and

an electrode layer, disposed on a side of the first planarization layer away from the base substrate; where the electrode layer includes a plurality of pixel electrodes, and the pixel electrodes are arranged to be at least partially overlapped with the corresponding first traces.

Optionally, the first planarization layer includes a plurality of second grooves; and the display panel further includes a second metal layer and a second planarization layer disposed between the first planarization layer and the electrode layer; where the second metal layer is disposed on a side of the first planarization layer away from the base substrate, the second metal layer includes a plurality of second traces disposed in a one-to-one correspondence with the plurality of second grooves, and the second traces are disposed in the corresponding second grooves; and the second planarization layer is disposed on a side of the second metal layer away from the base substrate, and the second planarization layer continuously covers the second traces and the first planarization layer.

Optionally, the pixel electrodes are further arranged to be at least partially overlapped with the corresponding second traces; and the first traces and the second traces are arranged to be at least partially overlapped with each other.

Optionally, the pixel electrodes are further arranged to be at least partially overlapped with the corresponding second traces; and the first traces are arranged to be not overlapped with the second traces.

Optionally, a depth of the first groove is greater than 0 and less than or equal to a thickness of the first trace; and a depth of the second groove is greater than 0 and less than or equal to a thickness of the second trace.

The present application further provides a display panel, including:

a base substrate;

a first metal layer, disposed on a side of the base substrate; where the first metal layer includes a plurality of first traces;

a first planarization layer, disposed on a side of the first metal layer away from the base substrate; where the first planarization layer continuously covers the first traces and the base substrate;

a second metal layer, disposed on a side of the first planarization layer away from the base substrate; where the second metal layer includes a plurality of second traces, and the second traces are arranged to be not overlapped with the first traces;

a second planarization layer, disposed on a side of the second metal layer away from the base substrate; where the second planarization layer continuously covers the second traces and the first planarization layer; and

an electrode layer, disposed on a side of the second planarization layer away from the base substrate; where the electrode layer includes a plurality of pixel electrodes, and the pixel electrodes are arranged to be at least partially overlapped with both the corresponding first traces and the corresponding second traces.

Optionally, the display panel further includes an insulating layer located between the base substrate and the first metal layer; where the insulating layer includes a plurality of first grooves disposed in a one-to-one correspondence with the plurality of first traces, and the first traces are disposed in the corresponding first grooves; where the first planarization layer includes a plurality of second grooves disposed in a one-to-one correspondence with the plurality of second traces, and the second traces are disposed in the corresponding second grooves.

Optionally, a side of the pixel electrode away from the base substrate is in a flat shape; the first planarization layer includes a first planar portion covering the first traces and a second planar portion covering the base substrate; and the second planarization layer includes a third planar portion covering the second traces and a fourth planar portion covering the first planarization layer; where a ratio between a thickness of the first planar portion and a thickness of the first trace is equal to a ratio between a thickness of the third planar portion and a thickness of the second trace; and a relationship between the thickness of the first planar portion and a thickness of the second planar portion, and a relationship between the thickness of the third planar portion and a thickness of the fourth planar portion are both as shown in a following formula:

$$d_1 = 6200 - 0.16 \times d_2$$

where $d_1$ represents the thickness of the first planar portion and $d_2$ represents the thickness of the second planar portion, or $d_1$ represents the thickness of the third planar portion and $d_2$ represents the thickness of the fourth planar portion; and a unit of $d_2$ is angstrom.

Optionally, the thickness of the first trace is equal to the thickness of the second trace; the thickness of the first planar portion is equal to the thickness of the third planar portion; and the thickness of the second planar portion is equal to the thickness of the fourth planar portion.

portion.

The present application further provides a display device, including the above-described display panel; where the display panel further includes a light-emitting functional layer located on the pixel electrodes.

For the display panel and the display device provided by the present application, by disposing the first grooves in the insulating layer and disposing the first traces in the first metal layer into the corresponding first grooves, the flatness of the entire first planarization layer can be effectively improved, thereby effectively improving the flatness of the pixel electrodes located on the first planarization layer; alternatively, by disposing the first traces in the first metal layer and the second traces in the second metal layer in a non-overlapping manner, the flatness of the second planarization layer located above the first traces and the second traces can be effectively improved, thereby effectively improving the flatness of the entire pixel electrodes; therefore, when forming the light-emitting functional layer on the surface of the pixel electrodes provided by the present application, protrusions on the surface of the light-emitting functional layer can be avoided, which is beneficial to improving the flatness of the surface of the light-emitting functional layer, that is, the flatness of the entire pixel surface can be improved, so that the color separation phenomenon during display of the display panel can be effectively reduced or even eliminated, thereby improving the display effect.

The following will clearly and completely describe the technical solutions in the embodiments of the present application in conjunction with the accompanying drawings in the embodiments of the present application. Obviously, the described embodiments are merely some rather than all of the embodiments of the present application. Based on the embodiments in the present application, all other embodiments obtained by those skilled in the art without creative labor shall fall within the protection scope of the present application.

In the description of the present application, it should be understood that the terms such as "center", "longitudinal", "transverse", "length", "width", "thickness", "upper", "lower", "front", "rear", "left", "right", "vertical", "horizontal", "top", "bottom", "inner", "outer", "clockwise", "counterclockwise" indicate orientations or positional relationships based on the orientations or positional relationships shown in the drawings, which are only for the convenience of describing the present application and simplifying the description, rather than indicating or implying that the referred device or element must have a specific orientation, be constructed and operated in a specific orientation, and thus cannot be understood as a limitation to the present application. In addition, the terms "first" and "second" are only used for descriptive purposes, and cannot be understood as indicating or implying relative importance or implicitly indicating the number of indicated technical features. Therefore, the features defined with "first" and "second" may explicitly or implicitly include one or more of the features. In the description of the present application, "a plurality of" means two or more, unless otherwise clearly and specifically defined.

In the present application, unless otherwise clearly specified and limited, a first feature being "on" or "under" a second feature may include the first and second features being in direct contact, or may include the first and second features not being in direct contact but being in contact through another feature between them. Moreover, a first feature being "on", "above" and "over" a second feature includes the first feature being directly above and obliquely above the second feature, or simply means that the first feature is at a higher horizontal level than the second feature. A first feature being "under", "below" and "beneath" a second feature includes the first feature being directly below and obliquely below the second feature, or simply means that the first feature is at a lower horizontal level than the second feature.

The following disclosure provides many different implementations or examples for realizing different structures of the present application. To simplify the disclosure of the present application, the components and settings of specific examples are described below. Of course, they are merely examples and are not intended to limit the present application. In addition, the present application may repeat reference numbers and/or reference letters in different examples, and such repetition is for the purpose of simplification and clarity, and does not itself indicate the relationship between the various implementations and/or settings discussed. In addition, the present application provides examples of various specific processes and materials, but those of ordinary skill in the art may be aware of the application of other processes and/or the use of other materials.

After research, the inventor found that the metal traces (such as source/drain (SD) traces) under the pixels of an OLED display panel are likely to cause protrusions of the planarization layer (PLN), thereby causing protrusions on the surface of the pixel electrodes (such as the anode layer ANO), making the pixel surface uneven. As shown in FIG. 3, the unevenness of the pixel electrode surface caused by double-layer SD traces (including SD1 and SD2) is more serious, especially when the two layers of SD traces are arranged to be completely overlapped, the protrusion phenomenon on the pixel electrode surface is more obvious. The protrusion of the pixel electrode surface makes the entire pixel surface protrude, and the unevenness of the pixel surface will lead to diffuse reflection on the pixel surface, making the display panel show a serious color separation phenomenon during display. In order to reduce or even eliminate the color separation phenomenon of the display panel, the present application provides a display panel and a display device, and specific reference is made to the descriptions of the following embodiments.

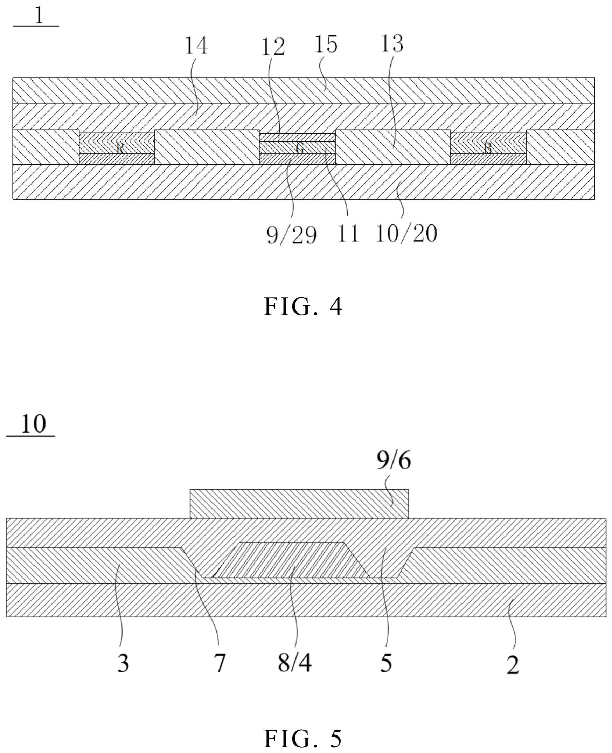

As shown in FIG. 4 and FIG. 5, an embodiment of the present application provides a display panel 1, and the display panel 1 includes a base substrate 2, an insulating layer 3, a first metal layer 4, a first planarization layer 5, and an electrode layer 6.

Specifically, the base substrate 2, the insulating layer 3, the first metal layer 4, the first planarization layer 5, and the electrode layer 6 constitute an array substrate 10 of the display panel 1.

Specifically, the base substrate 2 includes a thin film transistor array layer (not shown in the figure).

Specifically, the insulating layer 3 is disposed on a side of the base substrate 2, and the insulating layer 3 includes a plurality of first grooves 7. It can be understood that the depth of the first groove 7 is less than the thickness of the insulating layer 3, and the openings of the first grooves 7 are located on the side of the insulating layer 3 away from the base substrate 2.

Specifically, the insulating layer 3 may be an inorganic insulating layer, such as an interlayer dielectric layer (Inter-Layer Dielectric, ILD), but is not limited thereto.

Specifically, the first grooves 7 may be formed through exposure, development, and etching processes. When via holes or other slot structures need to be formed on the insulating layer 3, the first grooves 7 may be formed in the same process as the via holes or other slot structures; for example, the insulating layer 3 is first exposed and developed using a halftone mask, and then the patterned insulating layer 3 is obtained using an etching process.

Specifically, the first metal layer 4 is disposed on the side of the insulating layer 3 away from the base substrate 2, and is electrically connected to the thin film transistor array layer. The first metal layer 4 includes a plurality of first traces 8 disposed in a one-to-one correspondence with the plurality of first grooves 7, and the first traces 8 are disposed in the corresponding first grooves 7.

Specifically, the depth of the first groove 7 is greater than 0 and less than or equal to the thickness of the first trace 8. The inventor found through experimental research that the first traces 8 cause protrusions of the upper first planarization layer 5, and the ratio between the thickness of the protruding part of the first planarization layer 5 and the thickness of the first trace 8 is greater than 0 and less than 1; for example, the ratio between the thickness of the protruding part of the first planarization layer 5 and the thickness of the first trace 8 is 0.5. Therefore, in a preferred implementation manner, the depth of the first groove 7 is greater than 0 and less than the thickness of the first trace 8; for example, the depth of the first groove 7 is equal to 0.5 times the thickness of the first trace 8.

It should be noted that the "thickness" mentioned in the embodiments of the present application refers to the thickness of the film layer in the direction perpendicular to the base substrate 2, and the "depth" refers to the depth of the groove in the direction perpendicular to the base substrate 2.

Specifically, the first traces 8 may be the source/drain (SD) electrodes of the thin film transistor, or may be connecting lines, which is not limited here.

It can be understood that disposing the first traces 8 in the corresponding first grooves 7 can effectively reduce the height difference between the first traces 8 and the insulating layer 3.

Specifically, the first planarization layer 5 is disposed on the side of the first metal layer 4 away from the base substrate 2; where the first planarization layer 5 continuously covers the first traces 8 and the insulating layer 3.

Specifically, the material of the first planarization layer 5 is organic material.

It can be understood that due to the arrangement of the first grooves 7, the height difference between the first traces 8 and the insulating layer 3 is small; therefore, during the formation of the first planarization layer 5, the planarization layer material has good leveling property, and the first planarization layer 5 with a flat upper surface (i.e., the side away from the base substrate 2) can be formed. That is, the arrangement of the first grooves 7 is beneficial to forming the first planarization layer 5 with a upper surface in a flat shape.

Specifically, the electrode layer 6 is disposed on the side of the first planarization layer 5 away from the base substrate 2; where the electrode layer 6 includes a plurality of pixel electrodes 9, and the pixel electrodes 9 are arranged to be at least partially overlapped with the corresponding first traces 8.

In a specific implementation manner, the pixel electrodes 9 are arranged to be completely overlapped with the corresponding first traces 8.

In a specific implementation manner, as shown in FIG. 4, the display panel 1 is an OLED display panel, the pixel electrodes 9 are anodes (ANO), and a light-emitting functional layer 11 and a cathode layer 12 are sequentially formed on the pixel electrodes 9.

Since the pixel electrodes 9 are formed on the first planarization layer 5 and the upper surface of the first planarization layer 5 is in a flat shape, the upper surface of the pixel electrodes 9 (i.e., the side away from the base substrate 2) is also in a flat shape. Therefore, the upper surfaces of the light-emitting functional layer 11 and the cathode layer 12 sequentially formed on the pixel electrodes 9 are also in a flat shape, making the entire pixel surface in a flat shape.

It can be understood that the "pixel" described in the present application may be understood as a unit structure including the pixel electrode 9, and the light-emitting functional layer 11 and the cathode layer 12 disposed corresponding to the pixel electrode 9, or a unit structure including the pixel electrode 9 and the light-emitting functional layer 11.

Specifically, as shown in FIG. 4, the display panel 1 further includes a pixel definition layer 13, an encapsulation layer 14, and a protective layer 15, but is not limited thereto. The pixel definition layer 13 is located on the first planarization layer 5, and the pixel definition layer 13 includes a plurality of pixel openings disposed in a one-to-one correspondence with the plurality of pixel electrodes 9. The pixel openings expose part or all of the corresponding pixel electrodes 9, and part or all of the light-emitting functional layer 11 is formed in the pixel openings. The encapsulation layer 14 is disposed on the side of the cathode layer 12 away from the base substrate 2, and the protective layer 15 is disposed on the side of the encapsulation layer 14 away from the base substrate 2.

It should be noted that the area where the pixel electrodes 9 are located in the embodiments of the present application is a pixel area or a light-emitting area, and the positions of the first grooves 7 are not limited to the pixel area, but may also be located in a non-pixel area or a non-light-emitting area outside the pixel area. That is, the upper surface of the entire first planarization layer 5 in the embodiments of the present application is in a flat shape, and this design is beneficial to further improving the flatness of the light-emitting functional layer 11 and the cathode layer 12, thereby further improving the flatness of the pixel surface.

In embodiments of the present application, by disposing the first grooves 7 in the insulating layer 3 and disposing the first traces 8 in the first metal layer 4 into the corresponding first grooves 7, the flatness of the entire first planarization layer 5 can be effectively improved, thereby effectively improving the flatness of the pixel electrodes 9 located on the first planarization layer 5. Therefore, when forming the light-emitting functional layer 11 on the surface of the pixel electrodes 9 provided in embodiments of the present application, protrusions on the surface of the light-emitting functional layer 11 can be avoided, which is beneficial to improving the flatness of the surface of the light-emitting functional layer 11, that is, the flatness of the entire pixel surface can be improved, so that the color separation phenomenon during display of the display panel 1 can be effectively reduced or even eliminated, thereby improving the display effect.

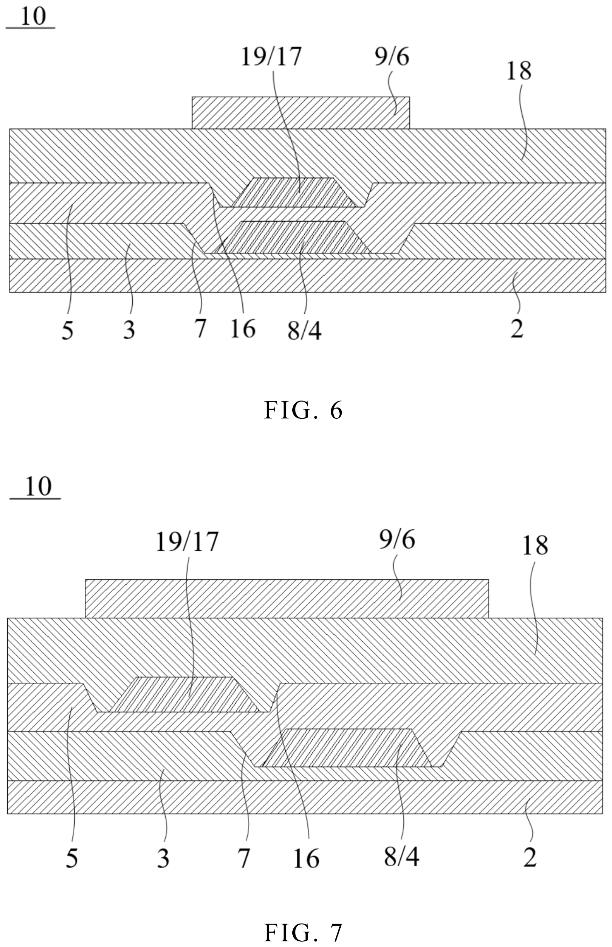

As shown in FIG. 4 and FIG. 6, embodiments of the present application further provide a display panel 1, which is different from the previous embodiments in the structure of the array substrate 10. Specifically, in embodiments of the present application, the first planarization layer 5 includes a plurality of second grooves 16; the display panel 1 further includes a second metal layer 17 and a second planarization layer 18 disposed between the first planarization layer 5 and the electrode layer 6. The second metal layer 17 is disposed on the side of the first planarization layer 5 away from the base substrate 2, the second metal layer 17 includes a plurality of second traces 19 disposed in a one-to-one correspondence with the plurality of second grooves 16, and the second traces 19 are disposed in the corresponding second grooves 16. The second planarization layer 18 is disposed on the side of the second metal layer 17 away from the base substrate 2, and the second planarization layer 18 continuously covers the second traces 19 and the first planarization layer 5.

Specifically, the depth of the second groove 16 is less than the thickness of the first planarization layer 5, and the openings of the second grooves 16 are located on the side of the first planarization layer 5 away from the base substrate 2.

Specifically, the depth of the second groove 16 is greater than 0 and less than or equal to the thickness of the second trace 19. In a preferred implementation manner, the depth of the second groove 16 is greater than 0 and less than the thickness of the second trace 19.

Specifically, the second grooves 16 may be formed through exposure, development, and etching processes. When via holes or other slot structures need to be formed on the first planarization layer 5, the second grooves 16 may be formed in the same process as the via holes or other slot structures.

Specifically, the second traces 19 may be the source/drain electrodes of the thin film transistor, or may be connecting lines, which is not limited here. It can be understood that disposing the second traces 19 in the corresponding second grooves 16 can effectively reduce the height difference between the second traces 19 and the first planarization layer 5.

Specifically, the material of the second planarization layer 18 is organic material. In a specific implementation manner, the material of the second planarization layer 18 and the first planarization layer 5 are the same.

It can be understood that due to the arrangement of the first grooves 7 and the second grooves 16, the height difference between the first traces 8 and the insulating layer 3 is small, and the height difference between the second traces 19 and the first planarization layer 5 is small. Therefore, during the formation of the second planarization layer 18, the planarization layer material has good leveling property, and the second planarization layer 18 with a flat surface can be formed. That is, the arrangement of the first grooves 7 and the second grooves 16 is beneficial to forming the second planarization layer 18 with a upper surface (i.e., the side away from the base substrate 2) in a flat shape.

Specifically, the pixel electrodes 9 are further arranged to be at least partially overlapped with the corresponding second traces 19. It can be understood that both the first traces 8 and the second traces 19 are located below the pixel electrodes 9. In a specific implementation manner, as shown in FIG. 6, the pixel electrodes 9 are arranged to be completely overlapped with both the first traces 8 and the second traces 19.

It should be noted that the pixel electrodes 9 being arranged to be completely overlapped with both the first traces 8 and the second traces 19 means that the orthographic projection of the pixel electrodes 9 on the base substrate 2 completely covers the orthographic projections of the first traces 8 and the second traces 19 on the base substrate 2.

In a specific implementation manner, the first traces 8 and the second traces 19 are arranged to be at least partially overlapped; for example, as shown in FIG. 6, the first traces 8 and the second traces 19 are arranged to be completely overlapped.

In the existing technology, without improving the film layer structure, the complete overlapping arrangement of two layers of traces will seriously affect the flatness of the planarization layer, resulting in low flatness of the pixel electrodes and color separation phenomenon during display of the display panel. However, in embodiments of the present application, by providing the first grooves 7 and the second grooves 16, the first traces 8 and the second traces 19 are respectively disposed in the corresponding first grooves 7 and second grooves 16, which effectively improves the flatness of the second planarization layer 18 and the pixel electrodes 9, thereby effectively reducing or even eliminating the color separation phenomenon during display of the display panel 1.

For example, in the display panel 1 provided in embodiments of the present application, the first traces 8 and the second traces 19 are arranged to be completely overlapped, the thickness of the insulating layer 3 is approximately 500 nm, and the thickness of the first planarization layer 5 is approximately 15000 nm. According to scanning electron microscope (SEM) section analysis, when no grooves are provided on the insulating layer 3 and the first planarization layer 5, protrusions will appear on the surface of the pixel electrodes 9, and the height of the protrusions is approximately 300 nm. For the display panel, on the basis of not changing the thicknesses of the film layers, when the sum of the depths of the first groove 7 and the second groove 16 is controlled to be approximately 300 nm, pixel electrodes 9 with flat upper surfaces can be obtained. It can be understood that for the display panel, the depths of the first groove 7 and the second groove 16 can be adjusted within the range greater than 0 and less than 300 nm, as long as the sum of the depths of the first groove 7 and the second groove 16 is approximately 300 nm.

In another specific implementation manner, the first traces 8 are arranged to be not overlapped with the second traces 19. For example, as shown in FIG. 7, the orthographic projection of the first traces 8 on the base substrate 2 is adjacent to the orthographic projection of the second traces 19 on the base substrate 2. On the basis of providing the first grooves 7 and the second grooves 16, disposing the first traces 8 and the second traces 19 in a non-overlapping manner can reduce the height difference between the first traces 8 and the second traces 19, which is beneficial to further improving the flatness of the second planarization layer 18 and the pixel electrodes 9, thereby effectively reducing or even eliminating the color separation phenomenon of the display panel 1.

It should be noted that in embodiments of the present application, the area where the pixel electrodes 9 are located is a pixel area or a light-emitting area, while the positions of the first grooves 7 and the second grooves 16 are not limited to the pixel area, but may also be located in a non-pixel area or a non-light-emitting area outside the pixel area. That is, the upper surface of the entire second planarization layer 18 in embodiments of the present application is in a flat shape, and this design is beneficial to further improving the flatness of the light-emitting functional layer 11 and the cathode layer 12, thereby further improving the flatness of the pixel surface.

It can be understood that embodiments of the present application do not limit the number of metal layers, and the traces in each metal layer can be disposed in the corresponding grooves to improve the flatness of the pixel electrodes 9.

In embodiments of the present application, by disposing the first grooves 7 in the insulating layer 3, disposing the second grooves 16 in the first planarization layer 5, and disposing the first traces 8 in the first metal layer 4 and the second traces 19 in the second metal layer 17 into the corresponding first grooves 7 and second grooves 16 respectively, the flatness of the entire second planarization layer 18 can be effectively improved, thereby effectively improving the flatness of the pixel electrodes 9 located on the second planarization layer 18. Therefore, when forming the light-emitting functional layer 11 on the surface of the pixel electrodes 9 provided in embodiments of the present application, protrusions on the surface of the light-emitting functional layer 11 can be avoided, which is beneficial to improving the flatness of the surface of the light-emitting functional layer 11, that is, the flatness of the entire pixel surface can be improved, so that the color separation phenomenon during display of the display panel 1 can be effectively reduced or even eliminated, thereby improving the display effect.

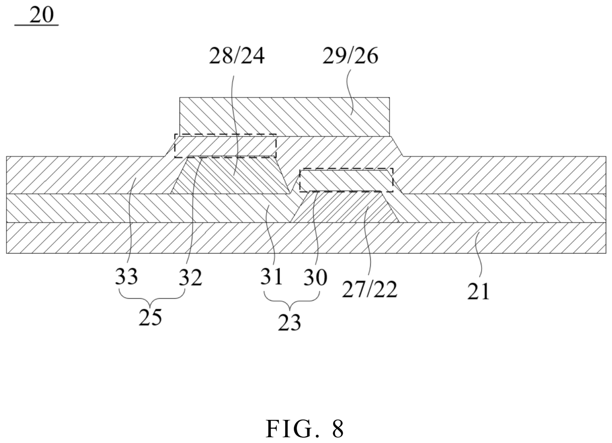

As shown in FIG. 4 and FIG. 8, embodiments of the present application further provide a display panel 1, and the display panel 1 includes a base substrate 21, a first metal layer 22, a first planarization layer 23, a second metal layer 24, a second planarization layer 25, and an electrode layer 26.

Specifically, the base substrate 21, the first metal layer 22, the first planarization layer 23, the second metal layer 24, the second planarization layer 25, and the electrode layer 26 constitute the array substrate 20.

Specifically, the base substrate 21 includes a thin film transistor array layer (not shown in the figure).

Specifically, the first metal layer 22 is disposed on a side of the base substrate 21, and the first metal layer 22 includes a plurality of first traces 27. The first traces 27 may be the source/drain (SD) electrodes of the thin film transistor, or may be connecting lines, which is not limited here.

Specifically, the first planarization layer 23 is disposed on the side of the first metal layer 22 away from the base substrate 21, and the first planarization layer 23 continuously covers the first traces 27 and the base substrate 21.

Specifically, the material of the first planarization layer 23 is organic material.

Specifically, the second metal layer 24 is disposed on the side of the first planarization layer 23 away from the base substrate 21; the second metal layer 24 includes a plurality of second traces 28, and the second traces 28 are arranged to be not overlapped with the first traces 27.

It should be noted that the second traces 28 being arranged to be not overlapped with the first traces 27 means that the distance between the orthographic projection of the second traces 28 on the base substrate 21 and the orthographic projection of the first traces 27 on the base substrate 21 is greater than or equal to 0.

In a preferred implementation manner, the distance between the orthographic projection of the second traces 28 on the base substrate 21 and the orthographic projection of the first traces 27 on the base substrate 21 is equal to 0. That is, the orthographic projection of the second traces 28 on the base substrate 21 is adjacent to the orthographic projection of the first traces 27 on the base substrate 21.

Specifically, the second planarization layer 25 is disposed on the side of the second metal layer 24 away from the base substrate 21, and the second planarization layer 25 continuously covers the second traces 28 and the first planarization layer 23.

Specifically, the material of the second planarization layer 25 includes organic material. In a specific implementation manner, the material of the second planarization layer 25 and the first planarization layer 23 are the same.

Specifically, the electrode layer 26 is disposed on the side of the second planarization layer 25 away from the base substrate 21; the electrode layer 26 includes a plurality of pixel electrodes 29, and the pixel electrodes 29 are arranged to be at least partially overlapped with both the corresponding first traces 27 and the corresponding second traces 28.

In a specific implementation manner, the pixel electrodes 29 are arranged to be completely overlapped with the corresponding first traces 27 and second traces 28.

Specifically, as shown in FIG. 4, the display panel 1 is an OLED display panel, the pixel electrodes 29 are anodes (ANO), and a light-emitting functional layer 11 and a cathode layer 12 are sequentially formed on the pixel electrodes 29.

It can be understood that in embodiments of the present application, disposing the first traces 27 and the second traces 28 below the pixel electrodes 29 in a non-overlapping manner can effectively reduce the height difference between the first traces 27 and the second traces 28, thereby being beneficial to improving the flatness of the second planarization layer 25 in the area where the pixel electrodes 29 are located, and thus being beneficial to improving the flatness of the pixel electrodes 29. In particular, when the orthographic projection of the second traces 28 on the base substrate 21 is adjacent to the orthographic projection of the first traces 27 on the base substrate 21, the continuity of the second planarization layer 25 above the adjacent first traces 27 and second traces 28 can be ensured, which is beneficial to further improving the flatness of the second planarization layer 25 in the area where the pixel electrodes 29 are located.

In a specific implementation manner, the display panel further includes an insulating layer located between the base substrate and the first metal layer; the insulating layer includes a plurality of first grooves disposed in a one-to-one correspondence with the plurality of first traces, and the first traces are disposed in the corresponding first grooves; the first planarization layer includes a plurality of second grooves disposed in a one-to-one correspondence with the plurality of second traces, and the second traces are disposed in the corresponding second grooves. On the basis of disposing the first traces and the second traces in a non-overlapping manner, by providing the first grooves and the second grooves, the height difference between the first traces and the second traces can be further reduced, which is beneficial to further improving the flatness of the pixel electrodes, thereby effectively reducing or even eliminating the color separation phenomenon of the display panel. Specifically, reference can be made to the structure shown in FIG. 7 for this design.

Specifically, as shown in FIG. 8, the side of the pixel electrodes 29 away from the base substrate 21 is in a flat shape. The first planarization layer 23 includes a first planar portion 30 covering the first traces 27 and a second planar portion 31 covering the base substrate 21; the second planarization layer 25 includes a third planar portion 32 covering the second traces 28 and a fourth planar portion 33 covering the first planarization layer 23.

Specifically, the ratio between the thickness of the first planar portion 30 and the thickness of the first trace 27 is equal to the ratio between the thickness of the third planar portion 32 and the thickness of the second trace 28. In a specific implementation manner, the ratio between the thickness of the first planar portion 30 and the thickness of the first trace 27 is 0.5, and the ratio between the thickness of the third planar portion 32 and the thickness of the second trace 28 is 0.5.

It can be understood that the thickness of the first planar portion 30 can be adjusted by adjusting the thickness of the first trace 27, and the thickness of the third planar portion 32 can be adjusted by adjusting the thickness of the second trace 28.

Specifically, the relationship between the thickness of the first planar portion 30 and the thickness of the second planar portion 31, and the relationship between the thickness of the third planar portion 32 and the thickness of the fourth planar portion 33 are both as shown in the following formula:

$$d_1 = 6200 - 0.16 \times d_2$$

where $d_1$ represents the thickness of the first planar portion 30 and $d_2$ represents the thickness of the second planar portion 31, or $d_1$ represents the thickness of the third planar portion 32 and $d_2$ represents the thickness of the fourth planar portion 33; and the unit of $d_2$ is angstrom.

It can be understood that the thickness of the first planar portion 30 can also be adjusted by adjusting the thickness of the second planar portion 31, and the thickness of the third planar portion 32 can also be adjusted by adjusting the thickness of the fourth planar portion 33.

It can be understood that the planarization of the second planarization layer 25 in the area where the pixel electrodes 29 are located can be achieved by adjusting the thicknesses of the first planar portion 30 and the third planar portion 32.

In a specific implementation manner, the thickness of the first trace 27 is equal to the thickness of the second trace 28, the thickness of the first planar portion 30 is equal to the thickness of the third planar portion 32, and the thickness of the second planar portion 31 is equal to the thickness of the fourth planar portion 33, so that the total thickness of the first planarization layer 23, the first trace 27, and the second planarization layer 25 in the area where the first traces 27 are located is equal to the total thickness of the first planarization layer 23, the second trace 28, and the second planarization layer 25 in the area where the second traces 28 are located, thereby achieving the planarization of the second planarization layer 25 in the area where the pixel electrodes 29 are located.

In another specific implementation manner, the thicknesses of the first planar portion 30 and the third planar portion 32 can be adjusted according to the relationship between the thickness of the first planar portion 30 and the thickness of the first trace 27 or the second planar portion 31, and the relationship between the thickness of the third planar portion 32 and the thickness of the second trace 28 or the fourth planar portion 33, so that the total thickness of the first planarization layer 23, the first trace 27, and the second planarization layer 25 in the area where the first traces 27 are located is equal to the total thickness of the first planarization layer 23, the second trace 28, and the second planarization layer 25 in the area where the second traces 28 are located, thereby achieving the planarization of the second planarization layer 25 in the area where the pixel electrodes 29 are located.

For example, it is measured through experiments that when the thicknesses of the second planar portion 31 and the fourth planar portion 33 are both approximately 2 microns, and the thicknesses of the first trace 27 and the second trace 28 are both approximately 7000 angstroms, the thicknesses of the first planar portion 30 and the third planar portion 32 are equal and approximately 3000 angstroms, and at this time, the upper surface of the pixel electrodes 29 is in a flat shape. Moreover, when the thicknesses of the second planar portion 31 and the fourth planar portion 33 are reduced to 1.5 microns, the thicknesses of the first planar portion 30 and the third planar portion 32 are equal and approximately 3800 angstroms, and at this time, the upper surface of the pixel electrodes 29 is also in a flat shape. Therefore, as the thickness of the second planar portion 31 decreases, the thickness of the first planar portion 30 located on the first traces 27 will gradually increase; similarly, as the thickness of the fourth planar portion 33 decreases, the thickness of the third planar portion 32 located on the second traces 28 will gradually increase; in addition, as the thickness of the first trace 27 decreases, the thickness of the first planar portion 30 will gradually decrease; similarly, as the thickness of the second trace 28 decreases, the thickness of the third planar portion 32 will gradually decrease.

In embodiments of the present application, disposing the first traces 27 in the first metal layer 22 and the second traces 28 in the second metal layer 24 in a non-overlapping manner can effectively improve the flatness of the second planarization layer 25 located above the first traces 27 and the second traces 28, thereby effectively improving the flatness of the entire pixel electrodes 29; therefore, when forming the light-emitting functional layer on the surface of the pixel electrodes 29 provided by the present application, protrusions on the surface of the light-emitting functional layer can be avoided, which is beneficial to improving the flatness of the surface of the light-emitting functional layer, that is, the flatness of the entire pixel surface can be improved, so that the color separation phenomenon during display of the display panel 1 can be effectively reduced or even eliminated, thereby improving the display effect.

The present application further provides a display device, which includes the display panel according to any of the above embodiments and a housing located at the periphery of the display panel.

The embodiments of the present application have the advantages described in the previous embodiments, and details are not repeated here.

In the above embodiments, the description of each embodiment focuses on different aspects. For parts not described in detail in a certain embodiment, reference can be made to the relevant descriptions of other embodiments.

The display panel and the display device provided by the embodiments of the present application have been introduced in detail above. Specific examples are used herein to illustrate the principles and implementation manners of the present application. The descriptions of the above embodiments are only used to help understand the technical solutions and the core ideas of the present application; those of ordinary skill in the art should understand that they can still modify the technical solutions recorded in the foregoing embodiments, or equivalently replace some of the technical features; and these modifications or replacements do not cause the essence of the corresponding technical solutions to deviate from the scope of the technical solutions of the embodiments of the present application.

**Claims**

1. A display panel, comprising:

   a base substrate;
   an insulating layer, disposed on a side of the base substrate; wherein the insulating layer comprises a plurality of first grooves;
   a first metal layer, disposed on a side of the insulating layer away from the base substrate; wherein the first metal layer comprises a plurality of first traces disposed in a one-to-one correspondence with the plurality of first grooves, and the first traces are disposed in the corresponding first grooves;
   a first planarization layer, disposed on a side of the first metal layer away from the base substrate; wherein the first planarization layer continuously covers the first traces and the insulating layer; and
   an electrode layer, disposed on a side of the first planarization layer away from the base substrate; wherein the electrode layer comprises a plurality of pixel electrodes, and the pixel electrodes are arranged to be at least partially overlapped with the corresponding first traces.

2. The display panel according to claim 1, wherein the first planarization layer comprises a plurality of second grooves; and the display panel further comprises a second metal layer and a second planarization layer disposed between the first planarization layer and the electrode layer;
   wherein the second metal layer is disposed on a side of the first planarization layer away from the base substrate, the second metal layer comprises a plurality of second traces disposed in a one-to-one correspondence with the plurality of second grooves, and the second traces are disposed in the corresponding second grooves; and the second planarization layer is disposed on a side of the second metal layer away from the base substrate, and the second planarization layer continuously covers the second traces and the first planarization layer.

3. The display panel according to claim 2, wherein the pixel electrodes are further arranged to be at least partially overlapped with the corresponding second traces; and the first traces and the second traces are arranged to be at least partially overlapped with each other.

4. The display panel according to claim 2, wherein the pixel electrodes are further arranged to be at least partially overlapped with the corresponding second traces; and the first traces are arranged to be not overlapped with the second traces.

5. The display panel according to claim 2, wherein a depth of the first groove is greater than 0 and less than or equal to a thickness of the first trace; and a depth of the second groove is greater than 0 and less than or equal to a thickness of the second trace.

6. A display device, comprising a display panel, wherein the display panel comprises:

a base substrate;
an insulating layer, disposed on a side of the base substrate; wherein the insulating layer comprises a plurality of first grooves;
a first metal layer, disposed on a side of the insulating layer away from the base substrate; wherein the first metal layer comprises a plurality of first traces disposed in a one-to-one correspondence with the plurality of first grooves, and the first traces are disposed in the corresponding first grooves;
a first planarization layer, disposed on a side of the first metal layer away from the base substrate; wherein the first planarization layer continuously covers the first traces and the insulating layer; and
an electrode layer, disposed on a side of the first planarization layer away from the base substrate; wherein the electrode layer comprises a plurality of pixel electrodes, and the pixel electrodes are arranged to be at least partially overlapped with the corresponding first traces;
wherein the display panel further comprises a light-emitting functional layer located on the pixel electrodes.

7. The display device according to claim 6, wherein the first planarization layer comprises a plurality of second grooves; and the display panel further comprises a second metal layer and a second planarization layer disposed between the first planarization layer and the electrode layer;
wherein the second metal layer is disposed on a side of the first planarization layer away from the base substrate, the second metal layer comprises a plurality of second traces disposed in a one-to-one correspondence with the plurality of second grooves, and the second traces are disposed in the corresponding second grooves; and the second planarization layer is disposed on a side of the second metal layer away from the base substrate, and the second planarization layer continuously covers the second traces and the first planarization layer.

8. The display device according to claim 7, wherein the pixel electrodes are further arranged to be at least partially overlapped with the corresponding second traces; and the first traces and the second traces are arranged to be at least partially overlapped with each other.

9. The display device according to claim 7, wherein the pixel electrodes are further arranged to be at least partially overlapped with the corresponding second traces; and the first traces are arranged to be not overlapped with the second traces.

10. The display device according to claim 7, wherein a depth of the first groove is greater than 0 and less than or equal to a thickness of the first trace; and a depth of the second groove is greater than 0 and less than or equal to a thickness of the second trace.

11. The display device according to claim 6, further comprising a housing located at a periphery of the display panel.

12. A display panel, comprising:

a base substrate;
a first metal layer, disposed on a side of the base substrate; wherein the first metal layer comprises a plurality of first traces;
a first planarization layer, disposed on a side of the first metal layer away from the base substrate; wherein the first planarization layer continuously covers the first traces and the base substrate;
a second metal layer, disposed on a side of the first planarization layer away from the base substrate; wherein the second metal layer comprises a plurality of second traces, and the second traces are arranged to be not overlapped with the first traces;
a second planarization layer, disposed on a side of the second metal layer away from the base substrate; wherein the second planarization layer continuously covers the second traces and the first planarization layer; and
an electrode layer, disposed on a side of the second planarization layer away from the base substrate; wherein the electrode layer comprises a plurality of pixel electrodes, and the pixel electrodes are arranged to be at least partially overlapped with both the corresponding first traces and the corresponding second traces.

13. The display panel according to claim 12, further comprising an insulating layer located between the base substrate and the first metal layer; wherein the insulating layer comprises a plurality of first grooves disposed in a one-to-one correspondence with the plurality of first traces, and the first traces are disposed in the corresponding first grooves;

wherein the first planarization layer comprises a plurality of second grooves disposed in a one-to-one correspondence with the plurality of second traces, and the second traces are disposed in the corresponding second grooves.

14. The display panel according to claim 12, wherein a side of the pixel electrode away from the base substrate is in a flat shape; the first planarization layer comprises a first planar portion covering the first traces and a second planar portion covering the base substrate; and the second planarization layer comprises a third planar portion covering the second traces and a fourth planar portion covering the first planarization layer;

wherein a ratio between a thickness of the first planar portion and a thickness of the first trace is equal to a ratio between a thickness of the third planar portion and a thickness of the second trace; and a relationship between the thickness of the first planar portion and a thickness of the second planar portion, and a relationship between the thickness of the third planar portion and a thickness of the fourth planar portion are both as shown in a following formula:

$$d_1 = 6200 - 0.16 \times d_2$$

wherein $d_1$ represents the thickness of the first planar portion and $d_2$ represents the thickness of the second planar portion, or $d_1$ represents the thickness of the third planar portion and $d_2$ represents the thickness of the fourth planar portion; and a unit of $d_2$ is angstrom.

15. The display panel according to claim 14, wherein the thickness of the first trace is equal to the thickness of the second trace; the thickness of the first planar portion is equal to the thickness of the third planar portion; and the thickness of the second planar portion is equal to the thickness of the fourth planar portion.

16. A display device, comprising a display panel, wherein the display panel comprises:

a base substrate;
an insulating layer, disposed on a side of the base substrate; wherein the insulating layer comprises a plurality of first grooves;
a first metal layer, disposed on a side of the insulating layer away from the base substrate; wherein the first metal layer comprises a plurality of first traces disposed in a one-to-one correspondence with the plurality of first grooves, and the first traces are disposed in the corresponding first grooves;
a first planarization layer, disposed on a side of the first metal layer away from the base substrate; wherein the first planarization layer continuously covers the first traces and the insulating layer;
an electrode layer, disposed on a side of the first planarization layer away from the base substrate; wherein the electrode layer comprises a plurality of pixel electrodes, and the pixel electrodes are arranged to be at least partially overlapped with the corresponding first traces;
wherein the display panel further comprises a light-emitting functional layer located on the pixel electrodes.

17. The display device according to claim 16, further comprising an insulating layer located between the base substrate and the first metal layer; wherein the insulating layer comprises a plurality of first grooves disposed in a one-to-one correspondence with the plurality of first traces, and the first traces are disposed in the corresponding first grooves;
wherein the first planarization layer comprises a plurality of second grooves disposed in a one-to-one correspondence with the plurality of second traces, and the second traces are disposed in the corresponding second grooves.

18. The display device according to claim 16, wherein a side of the pixel electrode away from the base substrate is in a flat shape; the first planarization layer comprises a first planar portion covering the first traces and a second planar portion covering the base substrate; and the second planarization layer comprises a third planar portion covering the second traces and a fourth planar portion covering the first planarization layer;

wherein a ratio between a thickness of the first planar portion and a thickness of the first trace is equal to a ratio between a thickness of the third planar portion and a thickness of the second trace; and a relationship between the thickness of the first planar portion and a thickness of the second planar portion, and a relationship between the thickness of the third planar portion and a thickness of the fourth planar portion are both as shown in a following formula:

$$d_1 = 6200 - 0.16 \times d_2$$

wherein $d_1$ represents the thickness of the first planar portion and $d_2$ represents the thickness of the second planar portion, or $d_1$ represents the thickness of the third planar portion and $d_2$ represents the thickness of the fourth planar portion; and a unit of $d_2$ is angstrom.

19. The display device according to claim 18, wherein the thickness of the first trace is equal to the thickness of the second trace; the thickness of the first planar portion is equal to the thickness of the third planar portion; and the thickness of the second planar portion is equal to the thickness of the fourth planar portion.

20. The display device according to claim 16, further comprising a housing located at a periphery of the display panel.

FIG. 1

FIG. 2

FIG. 3

_1_

14  12  15  13

R    G    B

9/29  11  10/20

FIG. 4

_10_

9/6

3    7    8/4    5    2

FIG. 5

FIG. 6

FIG. 7

FIG. 8

## INTERNATIONAL SEARCH REPORT

| International application No. |
|---|
| **PCT/CN2023/133823** |

### A.　CLASSIFICATION OF SUBJECT MATTER

H10K59/121(2023.01)i;　H10K59/12(2023.01)i;　H10K59/131(2023.01)i;　H10K59/124(2023.01)i

According to International Patent Classification (IPC) or to both national classification and IPC

### B.　FIELDS SEARCHED

Minimum documentation searched (classification system followed by classification symbols)

　　IPC：H10K H01L

Documentation searched other than minimum documentation to the extent that such documents are included in the fields searched

Electronic data base consulted during the international search (name of data base and, where practicable, search terms used)

　　CNABS; CNTXT; CNKI; VEN; USTXT; WOTXT; EPTXT: 华星光电, 显示, 京东方, 绝缘层, 凹槽, 平坦层, 走线, 金属层, 段差, display, BOE, insulating layer, groove, planarization layer, line, metal layer

### C.　DOCUMENTS CONSIDERED TO BE RELEVANT

| Category* | Citation of document, with indication, where appropriate, of the relevant passages | Relevant to claim No. |
|---|---|---|
| X | CN 214753763 U (BOE TECHNOLOGY GROUP CO., LTD. et al.) 16 November 2021 (2021-11-16) <br> description, paragraphs [0027]-[0065], and figures 1-4 | 1-20 |
| X | CN 114743988 A (YUNGU (GU'AN) TECHNOLOGY CO., LTD.) 12 July 2022 (2022-07-12) <br> description, paragraphs [0047]-[0098], and figures 1-14 | 1-20 |
| A | CN 115715106 A (BOE TECHNOLOGY GROUP CO., LTD. et al.) 24 February 2023 (2023-02-24) <br> entire document | 1-20 |
| A | CN 114530460 A (WUHAN CHINA STAR OPTOELECTRONICS SEMICONDUCTOR DISPLAY TECHNOLOGY CO., LTD.) 24 May 2022 (2022-05-24) <br> entire document | 1-20 |

☐ Further documents are listed in the continuation of Box C.　　☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **19 January 2024** | **24 January 2024** |

| Name and mailing address of the ISA/CN | Authorized officer |
|---|---|
| **China National Intellectual Property Administration (ISA/CN)** <br> **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/133823**

| Patent document cited in search report | | | Publication date (day/month/year) | Patent family member(s) | Publication date (day/month/year) |
|---|---|---|---|---|---|
| CN | 214753763 | U | 16 November 2021 | None | |
| CN | 114743988 | A | 12 July 2022 | None | |
| CN | 115715106 | A | 24 February 2023 | None | |
| CN | 114530460 | A | 24 May 2022 | None | |

Form PCT/ISA/210 (patent family annex) (July 2022)